**Europäisches Patentamt**

**European Patent Office**

**Office européen des brevets**

(19)

(11) **EP 1 047 290 A2**

(12) # EUROPEAN PATENT APPLICATION

(43) Date of publication:
**25.10.2000 Bulletin 2000/43**

(51) Int Cl.⁷: **H05K 1/02**

(21) Application number: **00303444.4**

(22) Date of filing: **25.04.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(30) Priority: **21.04.1999 JP 11420199**<br><br>(71) Applicant: **NEC CORPORATION**<br>**Tokyo (JP)** | (72) Inventor: **Suzuki, Mitsuo**<br>**Tokyo (JP)**<br><br>(74) Representative: **Orchard, Oliver John**<br>**JOHN ORCHARD & CO.**<br>**Staple Inn Buildings North**<br>**High Holborn**<br>**London WC1V 7PZ (GB)** |

(54) **Printing wiring board**

(57) A printed wiring board has slotted or grooved portions in a ground layer so as to be positioned under communication lines which are print-wired on the printed wiring board. Capacitors are provided between the slotted or grooved portions and external connecting terminals. Two units of oppositely directed magnetic flux of an equal level occur for the slotted or grooved portions by common mode currents flowing in the communication lines. These two units of magnetic flux offset each other to lower the common mode noise level.

FIG. 3

## Description

This invention relates to a printed wiring board. A particular printed wiring board to be described below by way of example in illustration of the present invention has a structure which facilitates the improvement of its electromagnetic environmental compatibility (hereinafter abbreviated to EMC).

With the recent development of digital techniques, and the degree of the use of the integration of LSI (Large Scale Integrated) circuits, the density of printed wiring boards has increased in recent years, and in addition the operating speed of circuits has also increased.

Such high-speed digital circuits carry digital signals containing many high-frequenc components. Consequently, it is necessary to suppress radioactive noise due to unnecessary radiation from a printed wiring board having a digital circuit.

Furthermore, since the resistance of a printed wiring board to external noise has been reduced due to the increase in the density and operating speed of digital devices, it is necessary to take measures to improve the noise resistance of a printed wiring board.

In order to improve the EMC of such digital devices and circuits, it has previously been proposed to mount a common mode choke on a printed wiring board.

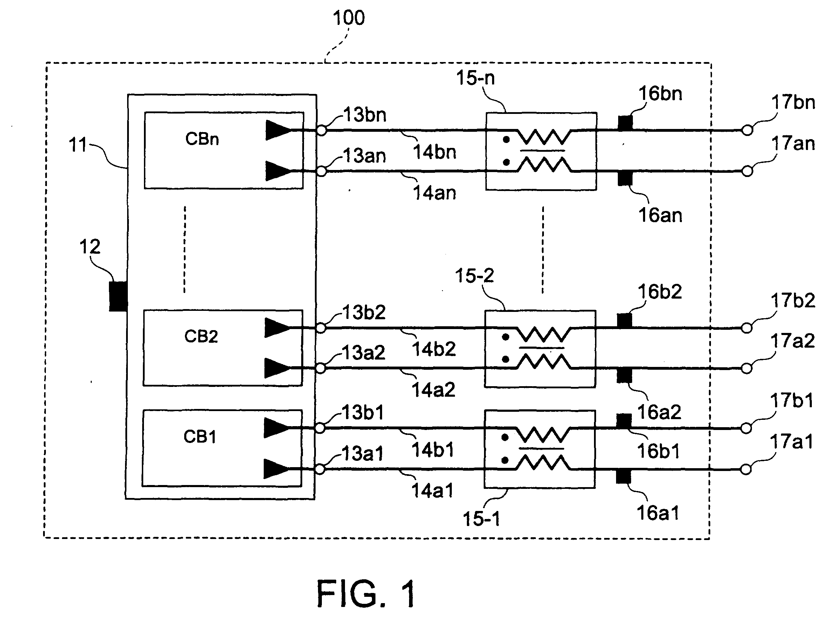

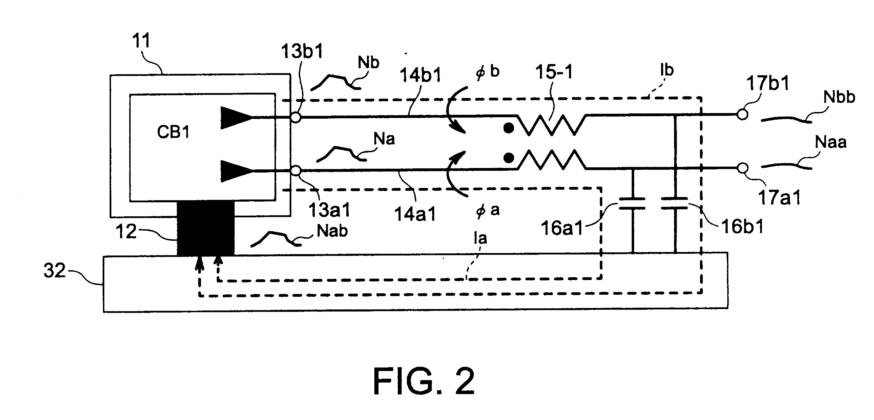

Reference will now be made to Figs. 1 and 2 of the accompanying drawings in which:

Fig. 1 shows the circuit arrangement of a previously proposed printed circuit wiring board, and
Fig. 2 shows common mode currents flowing in the circuit of Fig. 1.

In Fig. 1, reference numeral 11 denotes an LSI. The LSI 11 has circuit blocks CB1-CBn which are connected to pins 13a1, 13b1 to 13an, 13bn for communication lines and a common E (earth or ground) pin 12.

The pins 13a1,13b1 to 13an, 13bn for the communication lines are connected to common mode chokes 15-1 to 15-n the prevention of common mode noise via the communication lines 14a1, 14b1 to 14an, 14bn.

Capacitors 16a1, 16b1 to 16an,16bn having high-frequency characteristics are connected to portions of the communication lines between the common mode chokes 15-1 to 15-n and terminals 17a1, 17b1 to 17an, 17bn. On the other hand, the other terminals of the capacitors 16a1, 16b1 to 16an, 16bn are connected to a solid E (earth) layer 32 illustrated in Fig. 2.

Although a pair of communication lines 14a1, 14b1 alone is shown in Fig. 2, similar common mode noise may occur in the other communication lines. Reference numeral Nab in the same drawing denotes common mode noise occurring in the E pin 12. When the common mode noise Nab is generated in the E pin 12, common mode noise Na appears in the communication line 14a1, while common mode noise Nb is generated for the communication line 14B1.

Under this circumstance, a common mode current la passing through the communication line 14a1 flows along a path which passes via the common mode choke 15-1, capacitor 16a1, solid E layer 32 and communication pin 13a1. Thereby, the common mode current la generates magnetic flux $\phi$a.

In the meantime, a common mode current Ib passing through the communication line 14b1 flows along a path which passes via the common mode choke 15-1, capacitor 16b1, solid E layer 32 and communication pin 13b1. Thereby, the common mode current Ib generates magnetic flux $\phi$b.

Since the units of magnetic flux $\phi$a, and $\phi$b generate in the reverse direction to each other, $\phi$a, and $\phi$b offset each other. In consequence, the common mode noises Na, Nb are attenuated, with the levels of the common mode noises at the terminals 17a1, 17b1 being lowered.

As described above, expensive common mode chokes are used to suppress the occurrence of the common mode noise of the digital circuit and to improve the EMC in the related printed wiring board of this previously proposed arrangement.

A printed circuit wiring board will be described below by way of example in illustration of the present invention which is capable of suppressing common mode noise without the use of expensive components, such as a common mode choke as an EMC improving device.

In one arrangement to be described below by way of example in illustration of the present invention, a printed circuit wiring board has a laminate formed of a pattern-wired layer on which plural communication lines are print-wired, an insulating layer, and a ground layer, the printed wiring board including slotted portions (groove portions) in the sections of the ground layer which are positioned under two parallel-print-wired communication lines, and capacitors between the slotted portions and external connecting terminals of the printed wiring board, the capacitors being connected at one terminal thereof to the communication lines, and at the other terminal thereof to the ground layer via a through hole provided in the insulating layer.

In another arrangement to be described below by way of example in illustration of the present invention, the width of each of the slotted portions of the first-described printed wiring board is determined on the basis of the distance between the two parallel-print-wired communication lines.

In yet another arrangement to be described below, by way of example in illustration of the present invention, each of the capacitors in the first-described printed wiring board may be formed by the pattern-wired layer, an insulator being provided on the insulating layer and having a dielectric constant different from that of the insulating layer, and the ground layer.

The following description and drawings disclose, by means of examples the invention which is characterised in the appended claims, whose terms determine the extent of the protection conferred hereby.

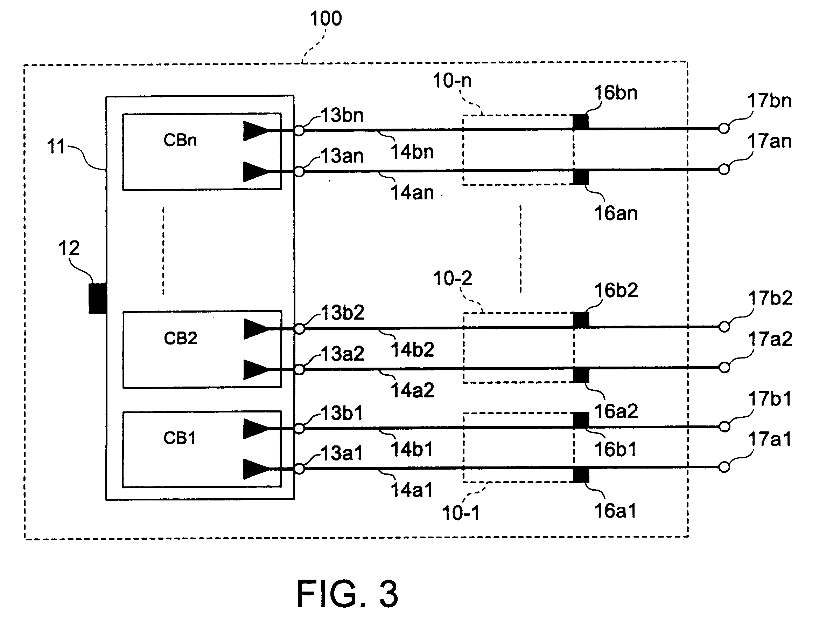

Fig. 3 illustrates a plan view of a printed circuit wiring board,

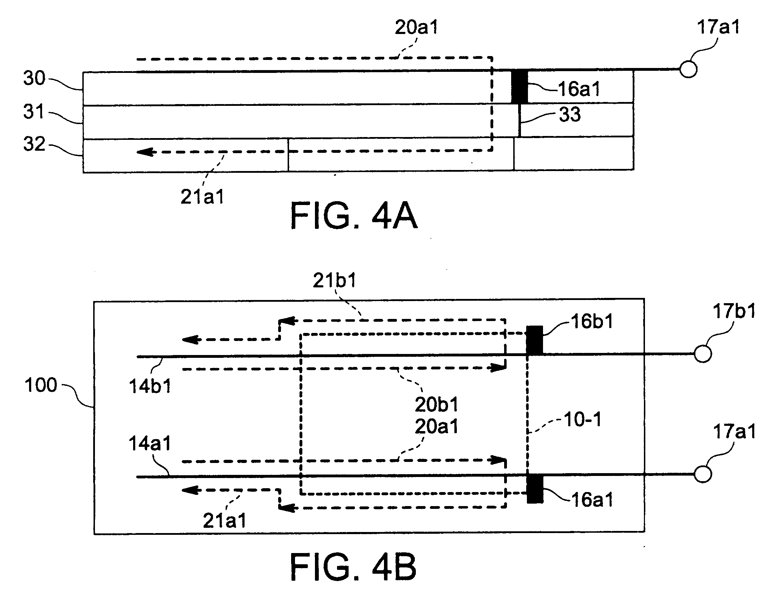

Fig. 4 illustrates common mode currents flowing in the circuit of the printed circuit wiring board of Fig. 1,

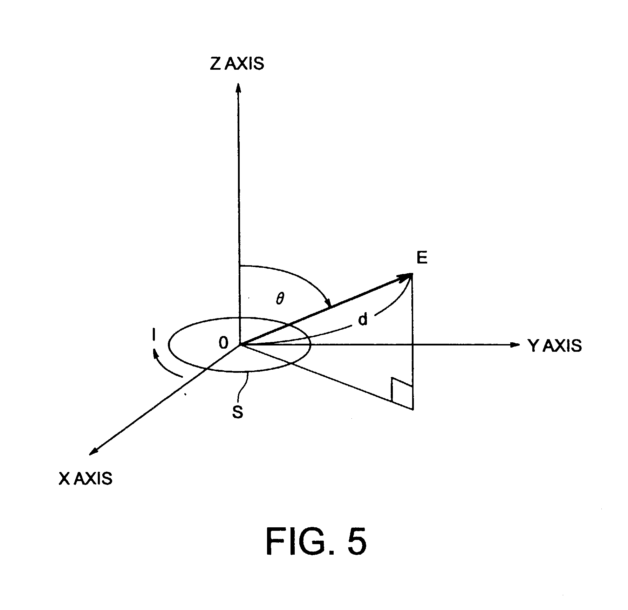

Fig. 5 is a schematic diagram illustrating the intensity of an electromagnetic wave occurring due to the loop currents shown in Figs. 4,

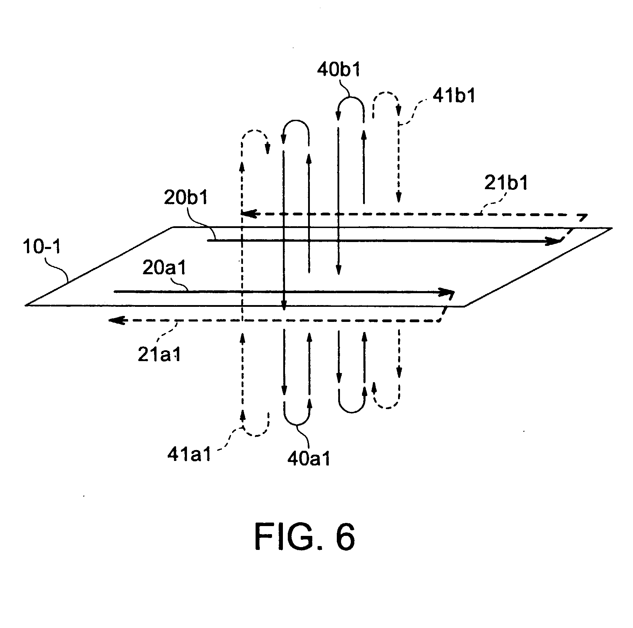

Fig. 6 is a schematic diagram illustrating the magnetic flux occurring due to the loop currents shown in Fig. 4,

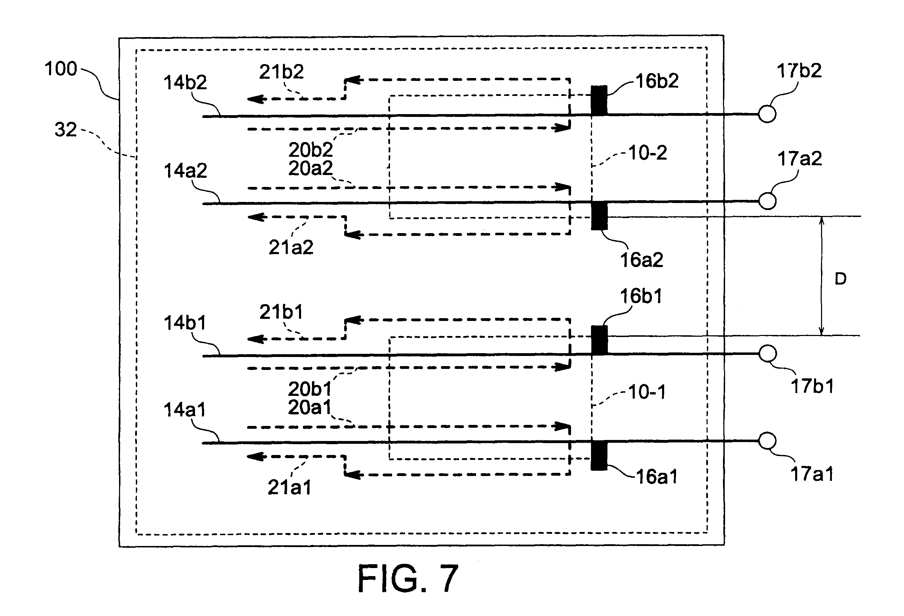

Fig. 7 is a plan view of the printed wiring board of Fig. 3 showing two pairs of signal lines print wired adjacently to each other and the common mode currents, and

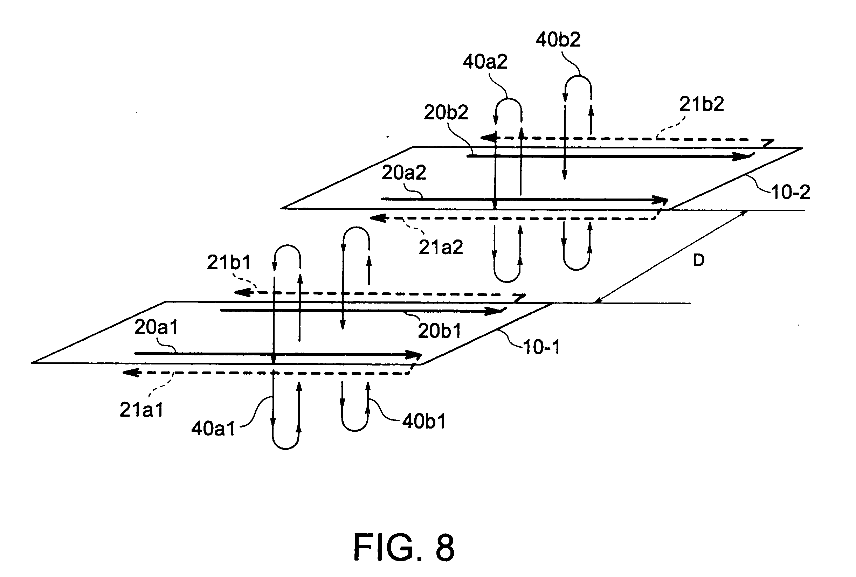

Fig. 8 is a schematic diagram illustrating the magnetic flux occurring due to the common mode currents of Fig. 7.

In the arrangement of Fig. 3 the printed circuit wiring board has elements which are common to those of the previously proposed printed circuit wiring board illustrated in Fig. 1 and which are designated by the same reference numerals, and therefore no further description of them will be made. In Fig. 3, reference numerals 10-1 to 10-n denote slotted portions (or groove portions) provided in a solid E layer 32. The slotted portions 10-1 to 10-n are provided so that they are positioned under paired print-wired communication lines 14a1, 14b1 to 14an, and 14bn.

Fig. 4 illustrates common mode currents 20a1, 20b1 flowing along the communication lines 14a1, 14b1, and common mode currents 21a1, 21b1 flowing through the solid E layer 32. The same applies to the other pairs of communication lines; they are therefore not described here.

In Fig. 4A, a printed circuit wiring board 100 is formed by laminating a pattern-wired layer 30, on which a wire pattern and parts are provided, an insulating layer 31, and a solid E layer 32.

With such a structure, the communication line 14a1 is print-wired onto the pattern-wired layer 30. Further, a capacitor 16a1 is connected to the communication line 14a1, and is coupled to the solid E layer 32 via a through hole 33 of the insulating layer 31 at the other terminal thereof. In this case, the communication line 14b1 and a capacitor 16b1 are also connected in the same manner.

In Fig. 4B, the common mode currents 20a1, 20b1, which are shown flowing along the paths illustrated in the same drawing, form loop currents with currents 21a1, 21b1 flowing through the solid E layer 32, which are positioned just under the communication lines 14a1, 14b1.

Fig. 5 is a schematic diagram illustrating the intensity of the electromagnetic wave occurring when the common mode currents 20a1, 20b1 flow.

The intensity E of the electromagnetic wave in a position spaced by a distance (d) from the centre of a loop area S and formed by a frequency (f) and a current I is defined as follows.

$$E = Kx \, (Sxlxf^2/d) \sin \theta$$

wherein S represents the area ($m^2$) of a current loop, I the loop current value (A), (f) the frequency (Hz) of the current loop, (d) the distance (m) from the centre of the current loop, $\theta$ the radiation angle (rad) with respect to the Z-axis of the electromagnetic wave, and K a constant.

Accordingly, the area S, the current I and the frequency (f) must be reduced, and the distance (d) must be increased in order to reduce the intensity of unnecessary radiation due to one loop current.

However, two loop currents flow adjacently to each other in the slotted portion 10-1. Consequently, electro-magnetic waves having the same intensity occur in reverse directions and offset or cancel each other. Therefore, a common mode current having a certain level is permitted.

Fig. 6 is a schematic diagram illustrating the magnetic flux occurring due to loop currents formed by the common mode currents 20a1, 20b1 flowing in the communication lines 14a1, 14b1 and the common mode currents 21a1, 21b1 flowing through the solid E layer 32.

Referring to Fig. 6, the loop current formed by the common mode currents 20a1, 21a1 generate a magnetic flux 40a1 in the slotted portion 10-1. The current 21a1 flowing through the solid E layer 32 generates a magnetic flux 41a1. However, this magnetic flux passes through the solid E layer 32.

Therefore, this magnetic flux is shielded by the solid E layer 32 and attenuated or caused to decay. Thereby, the intensity thereof is lowered. Consequently, the magnetic flux generated by the loop currents 20a1, 21a1 is constituted mainly by the magnetic flux 40a1 occurring in the slotted portion 10-1.

The magnetic fluxes 40b1, 41 b1 are generated in the same manner as mentioned above, due to a loop current formed by the common mode currents 20b1, 21 b1. However, the magnetic flux 41 b1 is attenuated due to the shielding effect of the solid E layer 32.

As a result, the magnetic flux occurring due to this loop current is mainly constituted by the magnetic flux 40b1 generated in the slotted portions 10-1.

Since noise levels occurring for the communication lines 14a1,14b1 are equal to each other, the common mode currents 20a1, 20b1 are equal to each other, and the magnetic fluxes 40a1, 40b1 generated by the currents are also equal to each other.

The directions of the magnetic fluxes 40a1, 40b1 passing through the slotted portion 10-1 are opposite to each other, and the levels of the same magnetic flux are equal. Therefore, the magnetic fluxes 40a1, 40b1 offset or cancel each other, and have the same effect as that obtained when the magnetic flux $\phi$a, and $\phi$b occurring due to the common mode choke 15-1 offset or cancel each other. This causes the common mode noise level to become lower.

The mutual influence of units of magnetic flux in a case in which two pairs of communication lines are arranged adjacently to each other will now be described.

Fig. 5 illustrates paired adjacently arranged communication lines 14a1, 14b1 and 14a2, 14b2, and Fig. 6 illustrates the magnetic flux occurring due to a loop current flowing in each communication line.

A description will now be made, with reference to Figs. 7 and 8, concerning the mutual influence of the magnetic flux when two units of the communication lines are arranged adjacent to each other.

In Fig. 8, the slotted portions 10-1 and 10-2 are spaced from each other by a distance D. The magnetic flux 40b1 is generated by the common mode current 20b1 on the side of the slotted portion (or groove portion) 10-1 which is adjacent to the slotted portion 10-2.

The magnetic flux 41 b1 occurring due to the common mode current 21 b1 is attenuated by the shielding effect of the solid E layer 32 as mentioned above. Consequently, only the magnetic flux 40b1 remains.

On the side of the slotted portion 10-2 which is adjacent to the slotted portion 10-1, magnetic flux 40a2 is generated by a current 20a2, and magnetic flux 41a2 (not shown) is generated by a current 21a2.

In the event that the distance between the slotted portions 10-1, 10-2 is small, the magnetic fluxes 41 b1, 41 a2 are cancelled by each other acting in opposite directions. In consequence, a difference occurs between the sum of the amounts of attenuation based on the offsetting of the units of magnetic fluxes 41b1, 41a2 upon each other, and the amount of attenuation based upon the shielding effect of the solid E layer 32 and the amount of attenuation based upon the shielding effect alone of the magnetic flux 41al.

Due to the influence of this difference, there is a difference between the magnitude of the magnetic flux 40a1 and that of the magnetic flux 40b1, and the offsetting amounts decrease.

The distance D may be increased by such an amount that it does not cause the magnetic fluxes 41 b1, 41a2 to influence one another other due to the shielding effect of the solid E layer. Thereby, the units of magnetic flux 40a1, 40b1 and 40a2, 40b2 offset or cancel each other, and any common mode noise can be minimised.

In the above described arrangement, a printed circuit wiring board using capacitors having high-frequency characteristics has been described. Instead of the capacitors, it is possible to arrange, in common, the portion of the high-frequency characteristics of the parts used so as to heighten the noise resistance of the digital circuit which corresponds to the capacity thereof.

It will be understood that, the arrangements described enable the EMC to be improved by a pattern designing method in which a slotted or grooved structure is provided in a ground layer without using expensive EMC improving parts. As a result, an economical printed wiring board can be obtained.

Since a slotted structure is employed without using electric parts, such as, common mode chokes, the reliability of the digital circuit-mounted printed wiring board can be enhanced.

It will be understood that, although particular arrangements illustrative of the invention have been described by way of example, variations and modifications thereof, as well as other arrangements may be made within the scope of the appended claims.

**Claims**

1. A printed wiring board, including a ground layer, an insulating layer the ground layer, a pattern wired layer on the insulating layer, a pair of communication lines on the pattern wired layer, a slotted or grooved portion in the ground layer, which portion is positioned under the communication lines, and capacitors between the slotted or grooved portion and external connecting terminals of the printed wiring board.

2. A printed wiring board as claimed in claim 1, wherein each of the capacitors is connected to each of the communication lines at one terminal, and is coupled to the ground layer via a through hole at the other terminal.

3. A printed wiring board as claimed in claim 2, wherein the through hole is provided in the insulating layer.

4. A printed wiring board as claimed in claim 1, wherein the communication lines are connected to a circuit block in an integrated circuit, the integrated circuit being arranged on the printed wiring board.

5. A printed wiring board, including, a ground layer, an insulating layer on the ground layer, a pattern wired layer on the insulating layer, plural pairs of communication lines on the pattern wired layer, slotted or grooved portions in the ground layer which portions are positioned under the communication lines, and capacitors between the respective slotted portions and external connecting terminals of the printed wiring board, the widths of the slotted or grooved portions being determined upon the basis of the distance between the respective adjacent pair of communication lines.

**6.** A printed wiring board as claimed in claim 5, wherein each of the capacitors is connected to each of the communication lines at one terminal, and is coupled to the ground layer via a through hole at the other terminal.

**7.** A printed wiring board as claimed in claim 6, wherein the through hole is provided in the insulating layer.

**8.** A printed wiring board as claimed in claim 5, wherein the communication lines are connected to circuit blocks in an integrated circuit, the integrated circuit being arranged on the printed wiring board.

FIG. 1

FIG. 2

FIG. 3

FIG. 4A

FIG. 4B

EP 1 047 290 A2

FIG. 5

FIG. 6

FIG. 7

FIG. 8

EP 1 047 290 A2